# EUROPEAN PATENT APPLICATION

(11) **EP 4 672 332 A1**
(43) Date of publication of application: **31.12.2025**
(21) Application number: 25182413.2
(22) Date of filing: 12.06.2025
(51) Int. Cl.: H01L 23/495, H01L 21/56, H01L 21/48, H01L 23/31, H01L 23/498, H01L 23/48

(54) **LEAD-FRAME PACKAGE WITH IMPROVED LEAD STRUCTURE**

(30) Priority: 25.06.2024 US 202463663956 P; 30.05.2025 US 202519223446
(71) Applicant: STMicroelectronics International N.V., 1228 Plan-les-Ouates, Geneva (CH)
(72) Inventor: TALLEDO, Jefferson Sismundo, 4027 Calamba (PH)
(74) Representative: Casalonga

(57) **Abstract**

An example lead-frame package, a method of manufacturing a lead-frame package, and an electrical system comprising a lead-frame package with improved conductive lead structure are provided. An example lead-frame package includes a semiconductor IC thermally coupled to a die pad. Molding material encloses the semiconductor IC defining a perimeter of the lead-frame package. A conductive lead is electrically connected to the semiconductor IC and exposed at a surface of the lead-frame package, the conductive lead having a proximal end and a distal end. The distal end of the conductive lead extends beyond the perimeter of the lead-frame package, the distal end bent vertically such that a solder wettable surface of the conductive lead is exposed in a lateral direction. The molding material further insulates the conductive lead from the die pad. A conductive lead recess is defined between the proximal end of the conductive lead and the die pad.

## Description

### CROSS-REFERENCE TO RELATED APPLICATIONS

This application claims the benefit of U.S. Provisional Patent Application No. 63/663,956, filed June 25, 2024, the entire contents of which are hereby incorporated by reference in their entirety.

### TECHNOLOGICAL FIELD

Embodiments of the present disclosure relate generally to lead-frame packages, and more particularly, to the structure of the conductive leads on a lead-frame package.

### BACKGROUND

Many electronic systems utilize printed circuit boards (PCBs) to support and connect the various electrical components of an electrical system. For example, a PCB may include a rigid structure with a plurality of mount regions configured to receive various electrical components. The PCB may further include conductive traces or paths to enable electrical connections between the various electrical components. A PCB may commonly receive surface-mounted and/or socketed electrical components, including various integrated circuits (ICs). One example structure for connecting an IC to a PCB is a lead-frame package.

Applicant has identified many technical challenges and difficulties associated with the structure of conductive leads in a lead-frame package. Through applied effort, ingenuity, and innovation, Applicant has solved problems related to conductive leads in a lead-frame package by developing solutions embodied in the present disclosure, which are described in detail below.

### BRIEF SUMMARY

Various embodiments are directed to an example lead-frame package, a method of manufacturing a lead-frame package, and an electrical system comprising a lead-frame package with improved conductive lead structure.

An example lead-frame package comprises a semiconductor integrated circuit (IC) thermally coupled to a die pad. Molding material encloses the semiconductor IC and defines a perimeter of the lead-frame package. A conductive lead is electrically connected to the semiconductor IC and is exposed at a surface of the lead-frame package, the conductive lead having a proximal end and a distal end. The distal end of the conductive lead extends beyond the perimeter of the lead-frame package, the distal end bent vertically such that a solder wettable surface of the conductive lead is exposed in a lateral direction. The molding material further insulates the conductive lead from the die pad. A conductive lead recess is defined between the proximal end of the conductive lead and the die pad.

In some embodiments, the conductive lead is electrically coupled to the semiconductor IC by a conductive bond wire.

In some embodiments, the conductive lead is attached to a conductive pad of a printed circuit board (PCB).

In some embodiments, the molding material comprises at least one of a resin and a polymer plastic.

In some embodiments, the lead-frame package comprises a quad-flat no-leads (QFN) package.

In some embodiments, the conductive lead further comprises a first side and a second side, wherein a first side recess is defined proximate the first side.

In some embodiments, a second side recess is defined proximate the second side.

In some embodiments, the conductive lead further comprises a distal end thickness, wherein an interior radius of the distal end of the conductive lead is equal to the distal end thickness.

In some embodiments, the solder wettable surface comprises a plating material configured to promote solder adhesion.

A method of manufacturing a lead-frame package is also provided. In some embodiments, the method comprises forming a conductive layer. The conductive layer comprising a dual conductive lead having a first portion and a second portion, and a die pad electrically insulated from the dual conductive lead. The method of manufacturing further comprising attaching a semiconductor integrated circuit (IC) to the die pad. Electrically connecting the first portion of the dual conductive lead to the semiconductor IC. Disposing a molding material around the semiconductor IC, wherein an exposed surface of the dual conductive lead is uncovered by the molding material. Etching a connecting portion of the dual conductive lead, wherein the connecting portion connects the first portion of the dual conductive lead to the second portion of the dual conductive lead. Performing a singulation process, separating the first portion of the dual conductive lead and electrically connected semiconductor IC from the second portion of the dual conductive lead. The singulation process defines a perimeter of the molding material of the lead-frame package comprising the semiconductor IC. The first portion of the dual conductive lead comprises a proximal end and a distal end, the distal end extending beyond the perimeter of the lead-frame package. Bending the distal end of the first portion of the dual conductive lead vertically such that a solder wettable surface of the first portion of the dual conductive lead is exposed in a lateral direction. Removing a portion of the molding material proximate the proximal end of the first portion of the dual conductive lead, between the first portion of the dual conductive lead and the die pad.

In some embodiments, etching the connecting portion of the dual conductive lead, is performed prior to performing the singulation process.

In some embodiments, performing the singulation process utilizes a laser cutting process.

In some embodiments, the second portion of the dual conductive lead comprises a portion of a second lead-frame package.

In some embodiments, bending the distal end of the first portion of the dual conductive lead vertically further comprises driving the lead-frame package into a forming pocket.

In some embodiments, the molding material comprises at least one of a resin and a polymer plastic.

In some embodiments, the lead-frame package comprises a quad-flat no-leads (QFN) package.

In some embodiments, the first portion of the dual conductive lead further comprises a first side and a second side. The method further comprising removing a first side portion of molding material proximate the first side of the first portion of the dual conductive lead.

In some embodiments, the method further comprises removing a second side portion of molding material proximate the second side of the first portion of the dual conductive lead.

In some embodiments, the first portion of the dual conductive lead further comprises a distal end thickness, wherein an interior radius of the distal end of the first portion of the dual conductive lead is equal to the distal end thickness.

An example electrical system is further provided. The example electrical system comprising a printed circuit board (PCB) comprising a conductive pad and a lead-frame package. The lead frame pack comprises a semiconductor integrated circuit (IC) thermally coupled to a die pad. A molding material enclosing the semiconductor IC and defining a perimeter of the lead-frame package. A conductive lead electrically connected to the semiconductor IC and exposed at a surface of the lead-frame package, the conductive lead having a proximal end and a distal end. The distal end of the conductive lead extends beyond the perimeter of the lead-frame package, the distal end of the conductive lead bent vertically such that a solder wettable surface of the conductive lead is exposed in a lateral direction relative to the surface of the PCB. The molding material insulates the conductive lead from the die pad. A conductive lead recess is defined between the proximal end of the conductive lead and the die pad. The distal end of the conductive lead is electrically connected to the conductive pad of the PCB.

### BRIEF DESCRIPTION OF THE DRAWINGS

Reference will now be made to the accompanying drawings. The components illustrated in the figures may or may not be present in certain embodiments described herein. Some embodiments may include fewer (or more) components than those shown in the figures in accordance with an example embodiment of the present disclosure.
FIG. 1 illustrates a cross-section view of an example lead-frame package with improved conductive leads in accordance with an example embodiment of the present disclosure.
FIG. 2A - FIG. 2C illustrate an example process for manufacturing a lead-frame package with improved conductive leads in accordance with an example embodiment of the present disclosure.
FIG. 3 illustrates an example conductive lead of a lead-frame package in accordance with an example embodiment of the present disclosure.
FIG. 4A - FIG. 4B illustrate a cross-section view of example recesses proximate the conductive lead in accordance with an example embodiment of the present disclosure.
FIG. 5 illustrates a cross-section view of an example electrical system including a printed circuit board (PCB) in accordance with an example embodiment of the present disclosure.
FIG. 6A - FIG. 6C illustrate an example process for manufacturing a lead-frame package with improved conductive leads in accordance with an example embodiment of the present disclosure.
FIG. 7 depicts an example method for manufacturing an improved conductive lead in accordance with an example embodiment of the present disclosure.

### DETAILED DESCRIPTION

Example embodiments will be described more fully hereinafter with reference to the accompanying drawings, in which some, but not all embodiments of the inventions of the disclosure are shown. Indeed, embodiments of the disclosure may be embodied in many different forms and should not be construed as limited to the embodiments set forth herein; rather, these embodiments are provided so that this disclosure will satisfy applicable legal requirements. Like numbers refer to like elements throughout.

Various embodiments of the present disclosure provide a method for manufacturing a lead-frame package with improved lead-frame structure, reducing the stress on the solder joints of the lead-frame package, especially when exposed to changes in temperature in an operating environment. As understood by those of skill in the field to which the present disclosure pertains, there are numerous example scenarios in which an improved lead-frame structure on a lead-frame package providing resilience to changes in an operating environment may be desired.

For example, many electronic systems utilize printed circuit boards (PCBs) to support and connect the various electrical components of an electrical system. A PCB may include a rigid structure with a plurality of mount regions configured to receive various electrical components. The PCB may further include conductive traces or paths to enable electrical connections between the various electrical components. A PCB may commonly receive surface-mounted and/or socketed electrical components, including various integrated circuits (ICs).

One example structure for connecting an IC to a PCB is a lead-frame package. A lead-frame package is a surface-mount technology providing structural support for an IC, protection from environmental factors, and an electrical connection between the PCB and the IC without through holes. Conductive surfaces (leads) on the bottom surface of the lead-frame package are coupled with conductive surfaces on the surface of the PCB. The lead-frame package protects the electrical components and electrical connections of the IC from environmental factors ensuring reliability of the electrical system even in extreme conditions. Example lead-frame packages include quad-flat no-leads (QFN) packages and quad-flat no-leads multi-row (QFNmr) packages.

Lead-frame packages coupled to PCBs may be required to withstand constant changes in temperature, particularly in harsh environments, such as in automotive applications. Changes in temperature may lead to expansion of various components of the electrical systems, for example, the PCB board, the attaching solder, the lead-frame package, etc. Expansion and compression of the electrical components may place stress on the solder joints, eventually causing solder cracks. Solder cracks may lead to failure of the IC utilizing the lead-frame package.

In some examples, the leads are extended from the perimeter of the lead-frame package and attached to the PCB to try and compensate for changes in the operating environment. However, such examples suffer a number of drawbacks. For example, the lead-frame packages are molded in individual cavities and separated using a punch tool. Molding individual lead-frame packages may be complex, slow, and otherwise inefficient. In addition, a lead-frame package with extended protrusions may occupy a larger PCB footprint.

The various example embodiments described herein utilize various techniques to reliably attach a lead-frame package to a substrate, such as a PCB, providing resilience to expansion and compression of electrical components during operation. For example, a process is provided for forming a conductive lead comprising a distal end extending past the perimeter of the lead-frame package. The conductive lead includes a solder wettable surface comprising a material, such as plating material, which promotes solder adhesion. The conductive lead is bent vertically such that the solder wettable surface is exposed to a lateral direction. In an instance in which solder is used to attach the lead-frame package to the contact pad of the PCB, the laterally facing solder wettable surface attaches to the solder. The vertically bent conductive lead provides greater flexibility and resilience in the lead-frame package connection to the PCB causing the conductive lead to flex as the PCB expands and contracts. The flexibility and resilience ensure more reliable electrical connections between the PCB and the semiconductor IC contained within the lead-frame package.

As further described herein, in some embodiments, one or more conductive lead recesses are formed between the proximal end of the conductive lead and the molding material used to form the lead-frame package and separate the conductive lead from the die pad. Such a conductive lead recess may be extended around the sides of the conductive lead. Creating a conductive lead recess behind and around the proximal end of the conductive lead enables greater flexibility in the lead structure. Greater flexibility increases the durability of the lead-frame package, particularly in an instance in which the PCB expands and compresses.

As a result of the herein described example embodiments, and in some examples, the reliability of semiconductor ICs utilizing a lead-frame package may be greatly improved. Improving the reliability of the electrical connection between the semiconductor IC and the substrate may increase the performance of the semiconductor IC, particularly in harsh environments. In addition, a lead-frame package in accordance with an example embodiment of the present disclosure may occupy less surface area on a substrate surface. Further, lead-frame packages in accordance with the present disclosure may be manufactured quickly and efficiently utilizing a single matrix array process, such as strip panel molding.

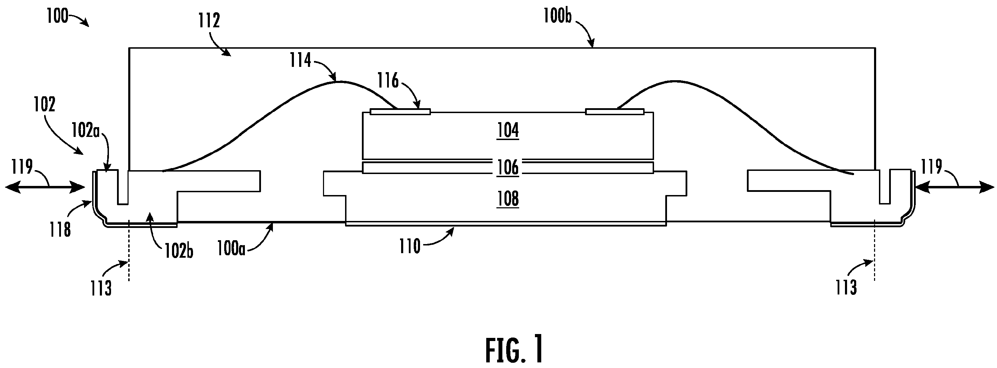

Referring now to FIG. 1, an example lead-frame package 100 is provided. As depicted in FIG. 1, the example lead-frame package 100 includes a semiconductor IC 104 attached to a die pad 108 with a die attach substance 106. The semiconductor IC 104 is electrically connected to a plurality of conductive leads 102 through a plurality of conductive bond wires 114 electrically connected to a plurality of IC contact points 116. The semiconductor IC 104 is enclosed in a molding material 112 defining a perimeter 113, a top surface 100b, and a bottom surface 100a of the lead-frame package 100. As further depicted in FIG. 1, the conductive leads 102 are bent vertically, exposing a solder wettable surface 118 in a lateral direction 119. A thermal conductive surface 110 is thermally coupled to the die pad 108 at a bottom surface of the lead-frame package 100.

A lead-frame package 100 is any structure for providing an electrical connection to a semiconductor IC 104 without the use of through-holes or exposed wire bonds. A lead-frame package 100 provides a surface-mount and/or socket mount from a semiconductor IC 104 contained within the molding material 112 of the lead-frame package 100 to an electrical system (e.g., a PCB). Conductive bond wires 114 are contained within the lead-frame package 100 with an electrical connection to the semiconductor IC 104 provided through a plurality of conductive leads 102 exposed on the bottom surface 100a of the lead-frame package 100. A lead-frame package 100 provides structural support to a semiconductor IC 104 and the conductive bond wires 114. The lead-frame package 100 further protects the electrical components, including the semiconductor IC 104, from the environmental factors of a surrounding environment, such as wind, rain, dirt, liquids, extreme temperatures, and so on. Non-limiting examples of lead-frame packages 100 may include quad-flat no-leads (QFN) packages, quad-flat no-leads multi-row (QFNmr) packages, dual-flat no-leads (DFN) packages, and so on. Although primarily depicted as a lead-frame package 100 comprising a molding material 112, in some embodiments, the lead-frame package 100 may comprise an air cavity lead-frame package.

As depicted in FIG. 1, the lead-frame package 100 includes a semiconductor IC 104. A semiconductor IC 104 (e.g., semiconductor die) is any circuitry including semiconductor material utilizing electrical components to perform one or more functions. A semiconductor IC 104 may include a processor, reconfigurable fabric, passive electrical components, active electrical components, memory, communications circuitry, and/or any other electrical components necessary to perform the functionality of the semiconductor IC 104. A semiconductor IC 104 is further configured to receive and/or generate one or more electrical signals. The one or more electrical signals are transmitted between the semiconductor IC 104 and an electrical system through one or more IC contact points 116 and corresponding conductive leads 102 electrically connected by conductive bond wires 114. As depicted in FIG. 1, the one or more conductive leads 102 provide an external conductive surface to electrically interface with the semiconductor IC 104.

As further depicted in FIG. 1, the semiconductor IC 104 of the example lead-frame package 100 is attached to a die pad 108 with a die attach substance 106. The die pad 108 comprises any thermally conductive material configured to transfer heat from the lead-frame package 100 to a fluid (e.g., air, liquid coolant) in the surrounding environment and/or to a thermal dissipation region of a mounting surface (e.g., PCB). A die pad 108 may comprise copper, aluminum, aluminum alloys, or other similar thermally conductive material. The material comprising a die pad 108 may depend on the application, heat intensity, production method, budget, and other factors. A die attach substance 106 is any bonding substance configured to enable a thermally conductive interface between the semiconductor IC 104 and the die pad 108. The die attach substance 106 enables the transfer of heat from the semiconductor IC 104 to the die pad 108. The die pad 108 is further thermally connected to a thermal conductive surface 110. The thermal conductive surface 110 is designed to interface with a thermal dissipation region of a mounting interface. The thermal conductive surface 110 enables efficient transfer of heat from the semiconductor IC 104 to a surrounding environment.

As further depicted in FIG. 1, the example lead-frame package 100 includes a molding material 112. The molding material 112 comprises any non-conductive material configured to protect a semiconductor IC 104 within the lead-frame package 100 from a surrounding environment. For example, in some embodiments, a semiconductor IC 104 may be on an electrical system in a harsh environment (e.g., high temperatures, low temperatures, exposed to dirt, water, dust, sand, etc.). In one such example, a lead-frame package 100 may be utilized to protect a semiconductor IC 104 in a portion of an automobile (e.g., engine, chassis, driveline, etc.). The molding material 112 may comprise a resin, polymer plastic, or other insulating material.

As depicted in FIG. 1, the molding material 112 is formed to define a bottom surface 100a, a top surface 100b, and a perimeter 113 of the lead-frame package 100. The conductive leads 102 are exposed at the bottom surface 100a of the lead-frame package 100 to provide a conductive path from an external electrical system to the semiconductor IC 104. The molding material 112 further defines a perimeter 113 of the lead-frame package 100. The perimeter 113 is the outermost boundary of the molding material 112 of the lead-frame package 100 in a lateral direction 119.

As further depicted in FIG. 1, the example lead-frame package 100 includes a plurality of conductive leads 102. A conductive lead 102 is any conductive surface configured to provide an electrical connection to a semiconductor IC 104 within a lead-frame package 100. In some embodiments, a conductive lead 102 may comprise copper, copper alloys, iron, tin, aluminum, or other similar electrically conductive material, The conductive leads 102 may be electrically coupled to distinct electrical components of the semiconductor IC 104 via an IC contact point 116 within the lead-frame package 100. For example, one conductive lead 102 may be electrically coupled to a clock, another may be electrically coupled to a reset signal, a third may be electrically coupled to an output signal of the semiconductor IC 104, and so on. The conductive leads 102 may be positioned to align with one or more conductive pads on the mounting surface of an electrical system (e.g., a PCB). The conductive leads 102 may enable a lead-frame package 100 to be electrically coupled to an electrical system utilizing surface-mount technologies, socket-mount technologies, or other similar mount technologies.

The conductive leads 102 further include a solder wettable surface 118. A solder wettable surface 118 is any surface of the conductive lead 102 configured to promote solder adhesion. For example, a solder wettable surface 118 may have a material deposited on the surface of the conductive lead to promote solder adhesion, for example, a plating material such as gold, copper, aluminum, silver, tin, etc. In some embodiments, the solder wettable surface 118 may be treated to promote solder adhesion. Further, in some embodiments, the solder used to attach the conductive lead 102 to an external electrical system may include materials to improve the wettability of the solder wettable surface 118.

As depicted in FIG. 1, the conductive leads 102 include a proximal end 102b and a distal end 102a. The proximal end 102b of the conductive lead 102 is within the perimeter 113 of the lead-frame package 100 and attached to the molding material 112. The distal end 102a of the conductive lead 102 extends beyond the perimeter 113 of the of the lead-frame package 100. As is depicted in FIG. 1, the distal end 102a of the conductive lead 102 is bent vertically (e.g., toward the top surface 100b of the lead-frame package 100). By bending the distal end 102a of the conductive lead 102 vertically, a surface of the distal end 102a of the conductive lead 102 (e.g., solder wettable surface 118) is exposed in a lateral direction. The solder wettable surface 118 may receive a portion of the solder in an instance in which the lead-frame package 100 is attached to an electrical system. The bent conductive lead 102 provides flexibility in a lateral direction 119 (e.g., parallel to the bottom surface 100a of the lead-frame package 100) as the bent conductive lead 102 flexes and expands. The resilience to lateral movement of the lead-frame package 100 enables the electrical connections of the lead-frame package 100 to remain intact in harsh environments.

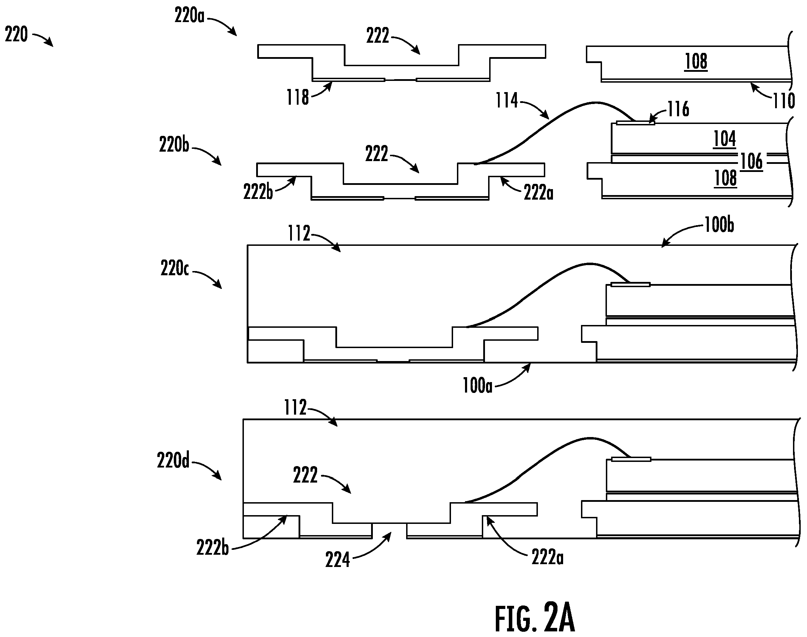

Referring now to FIG. 2A - FIG. 2C, an example process 220 for manufacturing a lead-frame package (e.g., lead-frame package 100) in accordance with the present disclosure is provided.

As depicted in FIG. 2A, at step 220a, a conductive layer is formed. The conductive layer includes a plurality of die pads 108 each configured to receive a semiconductor IC 104. In some embodiments, a conductive layer may include an array of die pads 108 organized in a series of rows and columns. In addition, the conductive layer includes a dual conductive lead 222. In some embodiments, a plurality of lead-frame packages 100 may be manufactured simultaneously using, for example, strip panel molding. During such a process, dual conductive leads 222 may be formed. A dual conductive lead 222 is a conductive feature comprising conductive leads for neighboring lead-frame packages 100. The dual conductive lead 222 is eventually separated into two portions (see step 220d), each portion providing a separate electrical connector to a semiconductor IC 104. Strip panel molding enables the manufacturing of large numbers of lead-frame packages 100 in a single process 220.

As further depicted in step 220a, a solder wettable material may be applied to the surface of the dual conductive lead 222, creating a solder wettable surface 118 on the dual conductive lead 222 for each lead-frame package. In addition, a thermal conductive surface 110 is formed on the bottom surface of the die pad 108.

At step 220b, a semiconductor IC 104 is attached to the die pad 108 using a die attach substance 106. In a strip panel molding process, a plurality of semiconductor ICs 104 are attached to each die pad 108 in the array of die pads 108. As further depicted at step 220b, conductive bond wires 114 are formed between the dual conductive lead 222 and the corresponding semiconductor IC 104. For example, a conductive bond wire 114 may be formed between a first portion 222a of the dual conductive lead 222 and the IC contact point 116 of the semiconductor IC 104.

At step 220c, a molding material 112 is disposed across the surface of the plurality of semiconductor ICs 104 with corresponding die pads 108 and dual conductive leads 222. For example, in a strip molding process, the molding material 112 is disposed across the entire surface of the conductive layer comprising a plurality of dual conductive leads 222 and semiconductor ICs 104. As shown in FIG. 2A, the molding material 112 fills in the gaps between the dual conductive leads 222 and the die pads 108. The molding material 112 acts as an electrical insulator between the dual conductive leads 222 and the die pads 108. The molding material 112 further defines the bottom surface 100a and the top surface 100b of the lead-frame packages. At least one exposed surface of the dual conductive lead 222 is left uncovered by the molding material 112.

At step 220d, a connecting portion 224 of the dual conductive lead 222 connecting the first portion 222a and the second portion 222b of the dual conductive lead 222 is etched. The dual conductive lead 222 is etched into two separate portions, the first portion 222a and the second portion 222b. However, the molding material 112 above and around the dual conductive lead 222 remains intact. The molding material 112 provides rigidity to the plurality of lead-frame packages during transfer and a singulation process. The etched connecting portion 224 may be removed using any wet etch (e.g., chemical etch), dry etch, or similar process.

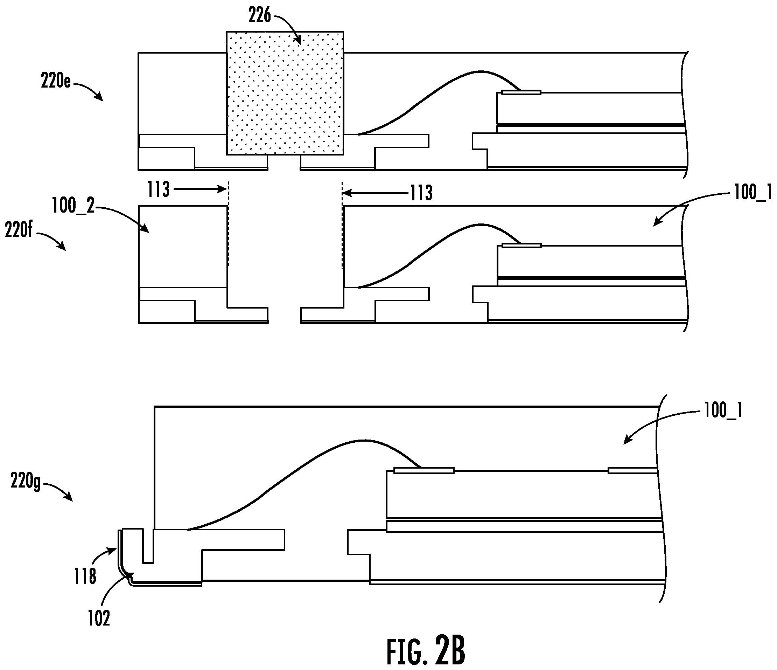

Referring now to FIG. 2B, at step 220e, a singulation process is performed. The singulation process removes the molding material 112 separating neighboring lead-frame packages. In a strip molding process, rows and columns are separated during the singulation process. The singulation process may include any process for cutting or removing the molding material 112 between lead-frame packages. For example, the singulation process may include a mechanical cutting process in which a rotating blade 226 is used to separate the lead-frame packages. In addition, the singulation process may include a laser cutting process in which a laser is used to cut the molding material 112 to separate the lead-frame packages.

As depicted in step 220f, once the molding material 112 is removed, the lead-frame packages 100_1, 100_2 are completely separated into separate lead-frame packages 100_1, 100_2. The singulation process further defines the boundary of each lead-frame package 100_1, 100_2 and the perimeter 113 of the lead-frame package 100_1, 100_2.

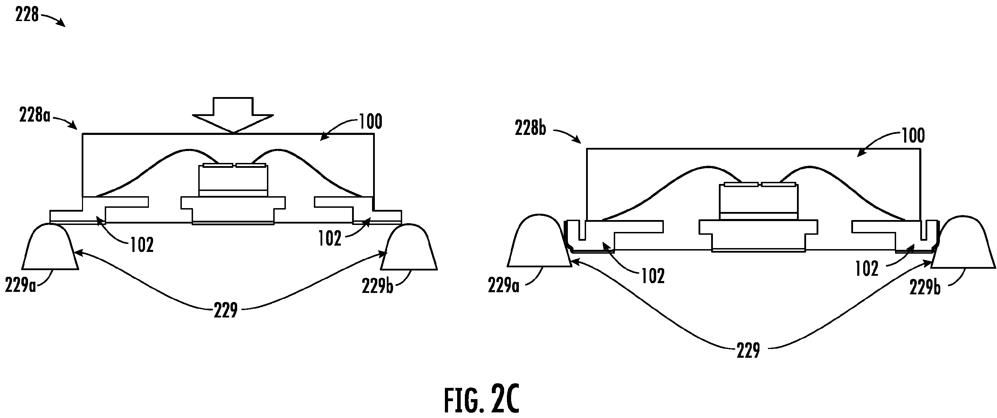

At step 220g, the conductive leads 102 are bent vertically, exposing a solder wettable surface 118 of the conductive lead 102 in a lateral direction. Any procedure or process may be utilized to vertically bend the conductive leads 102. FIG. 2C depicts one such example process for vertically bending the conductive leads 102.

Referring now to FIG. 2C, an example process 228 for vertically bending the conductive leads 102 of one or more lead-frame packages 100 is depicted.

As shown in step 228a, the lead-frame package 100 with conductive leads 102 extending past the perimeter defined by the molding material are pushed into a forming pocket 229 having a first protrusion 229a and a second protrusion 229b. The first protrusion 229a and the second protrusion 229b are spaced wider than the perimeter of the lead-frame package 100 but narrower than the full extent of the conductive leads 102, such that the downward force of the lead-frame package 100 into the forming pocket 229 causes the conductive leads 102 to bend vertically. In some embodiments, the first protrusion 229a and the second protrusion 229b may be rounded or otherwise shaped to promote the vertical bend of the conductive leads 102.

As shown in step 228b, in an instance in which the lead-frame package 100 is forced downward into the forming pocket 229, the conductive leads 102 extending outside the perimeter of the lead-frame package 100 are bent vertically. In some embodiments, a plurality of lead-frame packages 100 may be simultaneously forced into a forming pocket 229 such that the conductive leads 102 on a plurality of lead-frame packages are bent simultaneously. For example, in a strip molding process, an entire row or column of lead-frame packages 100 may be forced into a forming pocket 229 before the lead-frame packages of the row or column are separated.

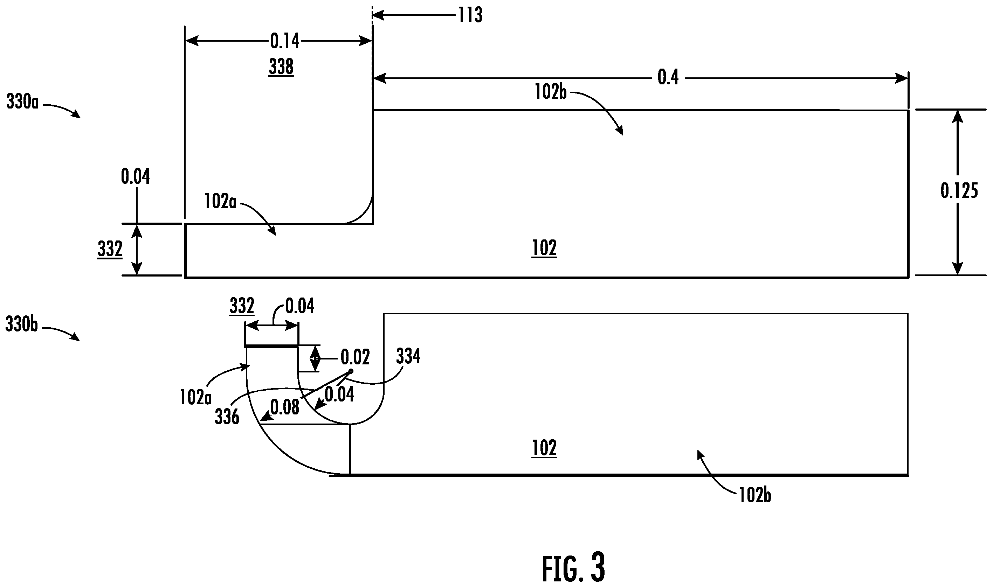

Referring now to FIG. 3, an example conductive lead 102 before bending 330a and after bending 330b is depicted.

As depicted in the before bending 330a state, the conductive lead 102 comprises a distal end 102a and a proximate end 102b. In some embodiments, the distal end 102a extends beyond the perimeter 113 of the molding material of the lead-frame package. The distal end 102a comprises a distal end thickness 332. In some embodiments, the distal end thickness 332 is between 0.03 millimeters and 0.06 millimeters; more preferably between 0.035 millimeters and 0.05 millimeters; most preferably between 0.0375 millimeters and 0.0425 millimeters. The distal end thickness 332 may determine the flexibility of the lead-frame package connection in a lateral direction. For example, a smaller distal end thickness 332 may provide more flexibility but less stability. Alternatively, a larger distal end thickness 332 may provide less flexibility but more stability.

As further depicted in the before bending 330a state, the conductive lead 102 comprises a distal end protrusion length 338. The distal end protrusion length 338 is the distance beyond the perimeter 113 of the lead-frame package to which the distal end 102a of the conductive lead 102 extends. In some embodiments, the distal end protrusion length 338 is between 0.1 millimeters and 0.4 millimeters; more preferably between 0.11 millimeters and 0.25 millimeters; most preferably between 0.12 millimeters and 0.18 millimeters.

As depicted in the after bending 330b state, the conductive lead 102 is bent vertically with an arc having an inner radius 334 and an outer radius 336. In some embodiments, the arc of the bend may be dependent upon the distal end thickness 332 of the distal end 102a. For example, as shown in Fig. 3, the inner radius 334 of the bent conductive lead 102 is equal to the distal end thickness 332 of the distal end 102a. Thus, in some embodiments, the ratio of the inner radius 334 to the distal end thickness 332 is between 0.75 and 1.25.

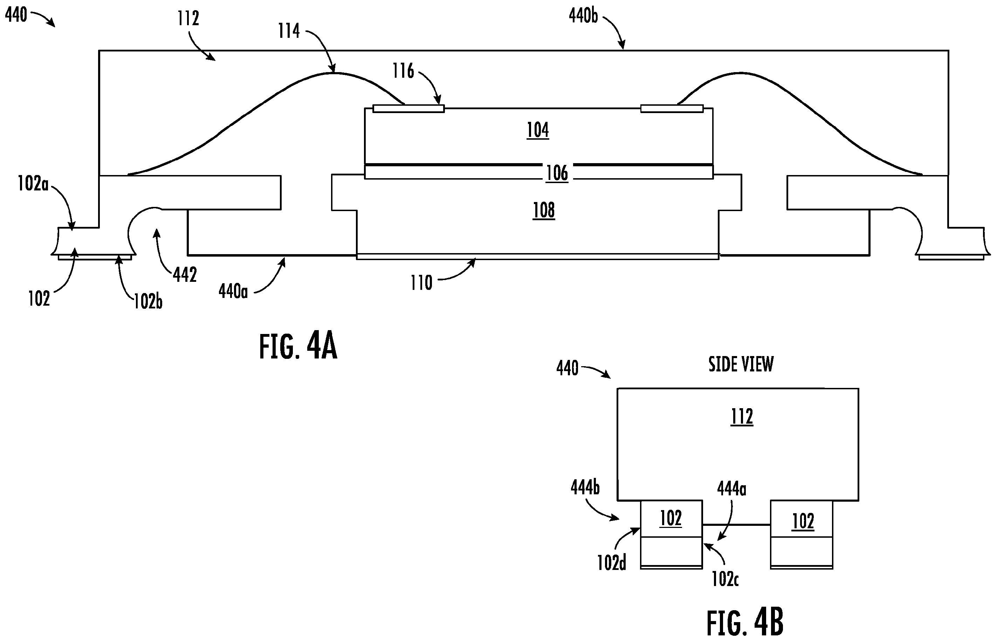

Referring now to FIG. 4A, a cross-section view of an example lead-frame package 440 is provided. As depicted in FIG. 4A, the example lead-frame package 440 includes a semiconductor IC 104 attached to a die pad 108 with a die attach substance 106. The semiconductor IC 104 is electrically connected to a plurality of conductive leads 102 through a plurality of conductive bond wires 114 electrically connected to a plurality of IC contact points 116. The semiconductor IC 104 is enclosed in a molding material 112 defining a top surface 440b and a bottom surface 440a of the lead-frame package 440. As further depicted in FIG. 4A, a conductive lead recess 442 is defined between the proximal end 102b of the conductive leads 102 and the die pad 108. A thermal conductive surface 110 is thermally coupled to the die pad 108 at a bottom surface 440a of the lead-frame package 440.

As depicted in FIG. 4A, a conductive lead recess 442 is defined between the proximal end 102b of the conductive lead 102 and the die pad 108. The conductive lead recess 442 comprises a cavity formed in the lead-frame package 440 proximate the proximal end 102b of the conductive lead 102 enabling greater flexibility in the conductive lead 102, particularly in an instance in which force is applied to the conductive lead 102 in a lateral direction 119. In some examples, force may be applied through expansion and compression of the system components due to changes in temperature. In some embodiments, the conductive lead recess 442 may be formed by removing a portion of the proximal end 102b of the conductive lead 102 at the intersection of the conductive lead 102 and the molding material 112 between the conductive lead 102 and the die pad 108. Removal of a portion of the proximal end 102b of the conductive lead 102 may be performed by etching (e.g., chemical etching), laser cutting, mechanical blade, or other similar process. In some embodiments, the conductive lead recess 442 may be formed by removing a portion of the molding material 112 at the intersection of the conductive lead 102 and the molding material 112 between the conductive lead 102 and the die pad 108, for example, using a laser cutting or mechanical blade process.

Referring now to FIG. 4B, a side view of a portion of an example lead-frame package 440 is depicted. As depicted in FIG. 4B, the conductive lead 102 comprises a first side 102c and a second side 102d. A first side recess 444a is formed on the first side 102c of the conductive lead 102. As further depicted in FIG. 4B, a second side recess 444b is formed on the second side 102d of the conductive lead 102. Thus, as shown in combination with FIG. 4A, a recess may be formed around the conductive lead 102 comprising the first side recess 444a, the second side recess 444b and the conductive lead recess 442. In some embodiments, first side recess 444a, the second side recess 44b, and the conductive lead recess 442 may interconnect. Defining one or more recesses around the conductive lead 102 provide additional flexibility to the conductive lead 102, particularly flexibility to withstand forces in a lateral direction (e.g., parallel to the bottom surface 440a of the lead-frame package 440). The first side recess 444a and the second side recess 444b may be formed by removing a first side portion and a second side portion of molding material 112 respectively. The first side portion includes the molding material proximate the first side 102c of the conductive lead 102. The second side portion includes the molding material proximate the second side 102d of the conductive lead 102. In some embodiments, the first side recess 444a and the second side recess 444b may be formed by removing a portion of the first side 102c of the conductive lead 102 and a portion of the second side 102d of the conductive lead 102 respectively. The first side recess 444a and the second side recess 444b may be formed by etching, laser cutting, mechanical blade, or any combination thereof.

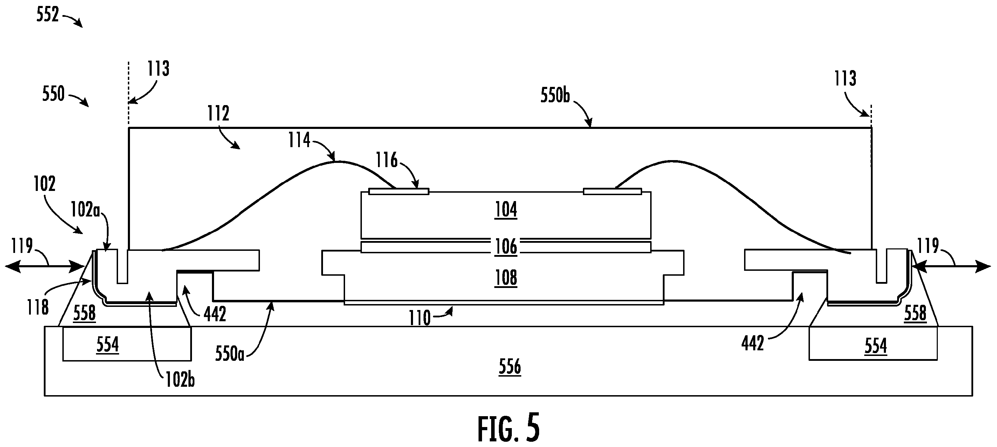

Referring now to FIG. 5, an example electrical system 552 comprising a lead-frame package 550 with vertically bent conductive leads 102 and a plurality of conductive lead recesses 442 is provided. As depicted in FIG. 5, the example lead-frame package 550 includes a semiconductor IC 104 attached to a die pad 108 with a die attach substance 106. The semiconductor IC 104 is electrically connected to a plurality of conductive leads 102 through a plurality of conductive bond wires 114 electrically connected to a plurality of IC contact points 116. The semiconductor IC 104 is enclosed in a molding material 112 defining a perimeter 113, a top surface 550b, and a bottom surface 550a of the lead-frame package 550. As further depicted in FIG. 5, the conductive leads 102 are bent vertically, exposing a solder wettable surface 118 in a lateral direction 119. In addition, a conductive lead recess 442 is formed proximate the proximal end 102b of the conductive lead 102 at the intersection of the conductive lead 102 and the molding material 112. A thermal conductive surface 110 is thermally coupled to the die pad 108 at a bottom surface of the lead-frame package 550.

As further depicted in FIG. 5, the lead-frame package 550 is electrically connected to a printed circuit board (PCB) 556. The electrical connection is formed between each of the conductive leads 102 and the PCB 556 at a conductive pad 554 on the surface of the PCB 556. The electrical connection is made by applying a fusible conductive material (e.g., solder 558) between the conductive pad 554 and the solder wettable surface 118 of the bent conductive lead 102.

As depicted in FIG. 5, an example electrical system 552 comprises any combination of electrical components interconnected through a substrate material (e.g., PCB 556). The PCB 556 is a structure comprising laminated layers of conductive and insulating material, providing rigid structure and electrical connections between various electrical components (e.g., lead-frame packages 100, 440, 550) of the electrical system 552. A PCB 556 may utilize copper or a similar conductor to form electrical paths between the electrical components comprising the electrical system 552. The conductive layers may be accompanied by one or more insulating layers. Insulating layers may be comprised of an insulating material, such as fiberglass. A PCB 556 may enable the integration of one or more electrical components by surface mount technologies. Surface mount technologies provide for attaching electrical components directly to the surface of a PCB 556. Surface mount technologies enable increased automation in the manufacture of circuits utilizing a PCB 556. In addition, surface mount technologies reduce cost and improve the quality and reliability of the electrical system 552.

A PCB 556 may include a plurality of conductive pads 554 configured to interface with the conductive leads 102 of a lead-frame package 550. A conductive pad 554 is any conductive portion on a surface of a PCB 556 configured to provide an electrical connection to one or more electrical paths on the PCB 556. A conductive pad 554 may comprise copper or another similar conductive material. The conductive pads 554 may be configured to align with the conductive leads 102 of a lead-frame package 550. A conductive bond such as solder 558, may be utilized to attach the conductive leads 102 of the lead-frame package 550 to the conductive pads 554 of the PCB 556.

As further depicted in FIG. 5, the example lead-frame package 550 comprises both bent conductive leads 102 and conductive lead recesses 442 proximate the proximal ends 102b of the conductive leads 102. As is depicted in FIG. 1, the distal end 102a of the conductive lead 102 is bent vertically (e.g., toward the top surface 550b of the lead-frame package 550). By bending the distal end 102a of the conductive lead 102 vertically, a surface of the distal end 102a of the conductive lead 102 (e.g., solder wettable surface 118) is exposed in a lateral direction. The solder wettable surface 118 receives a portion of the solder 558 attaching the lead-frame package 550 to the electrical system 552. The bent conductive lead 102 provides flexibility in a lateral direction 119 (e.g., parallel to the bottom surface 550a of the lead-frame package 550) as the bent conductive lead 102 flexes and expands. The resilience to lateral movement of the lead-frame package 550 enables the electrical connections of the lead-frame package 100 to remain intact in harsh environments.

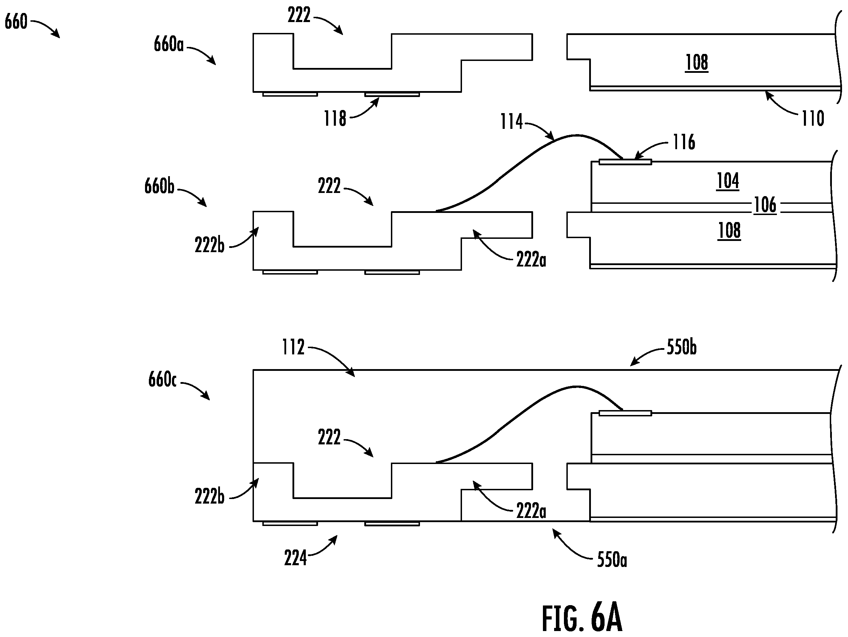

Additional flexibility and resilience to movement in a lateral direction 119 is provided by the conductive lead recesses 442. The conductive lead recesses 442 comprises a cavity formed in the lead-frame package 550 proximate the proximal end 102b of the conductive lead 102 enabling greater flexibility in the conductive lead 102, particularly in an instance in which force is applied to the conductive lead 102 in a lateral direction 119. Although not depicted in FIG. 5, the lead-frame package 550 may also include side recesses (e.g., first side recess 444a, second side recess 444b) at the conductive lead 102. The conductive lead recesses 442 and side recesses may be formed by etching, laser cutting, mechanical blade, or other similar process. The process for manufacturing a lead-frame package 550 in accordance with FIG. 5 is depicted in FIG. 6A - FIG. 6C.

Referring now to FIG. 6A - FIG. 6C, an example process 660 for manufacturing a lead-frame package (e.g., lead-frame package 550) in accordance with the present disclosure is provided.

As depicted in FIG. 6A, at step 660a, a conductive layer is formed. The conductive layer includes a plurality of die pads 108 each configured to receive a semiconductor IC 104. In some embodiments, a conductive layer may include an array of die pads 108 organized in a series of rows and columns. In addition, the conductive layer includes a dual conductive lead 222. In some embodiments, a plurality of lead-frame packages 100 may be manufactured simultaneously using, for example, strip panel molding. During such a process, dual conductive leads 222 may be formed. A dual conductive lead 222 is a conductive feature comprising conductive leads for neighboring lead-frame packages 550. The dual conductive lead 222 is eventually separated into two portions (see step 660d), each portion providing a separate electrical connector to a semiconductor IC 104. Strip panel molding enables the manufacturing of large numbers of lead-frame packages 550 in a single process 660.

As further depicted in step 660a, a solder wettable material may be applied to the surface of the dual conductive lead 222, creating a solder wettable surface 118 on the dual conductive lead 222 for each lead-frame package. In addition, a thermal conductive surface 110 is formed on the bottom surface of the die pad 108.

At step 660b, a semiconductor IC 104 is attached to the die pad 108 using a die attach substance 106. In a strip panel molding process, a plurality of semiconductor ICs 104 are attached to each die pad 108 in the array of die pads 108. As further depicted at step 660b, conductive bond wires 114 are formed between the dual conductive lead 222 and the corresponding semiconductor IC 104. For example, a conductive bond wire 114 may be formed between a first portion 222a of the dual conductive lead 222 and the IC contact point 116 of the semiconductor IC 104.

At step 660c, a molding material 112 is disposed across the surface of the plurality of semiconductor ICs 104 with corresponding die pads 108 and dual conductive leads 222. For example, in a strip molding process, the molding material 112 is disposed across the entire surface of the conductive layer comprising a plurality of dual conductive leads 222 and semiconductor ICs 104. As shown in step 660c, the molding material 112 fills in the gaps between the dual conductive leads 222 and the die pads 108. The molding material 112 acts as an electrical insulator between the dual conductive leads 222 and the die pads 108. The molding material 112 further defines the bottom surface 100a and the top surface 100b of the lead-frame packages. At least one exposed surface of the dual conductive lead 222 is left uncovered by the molding material 112.

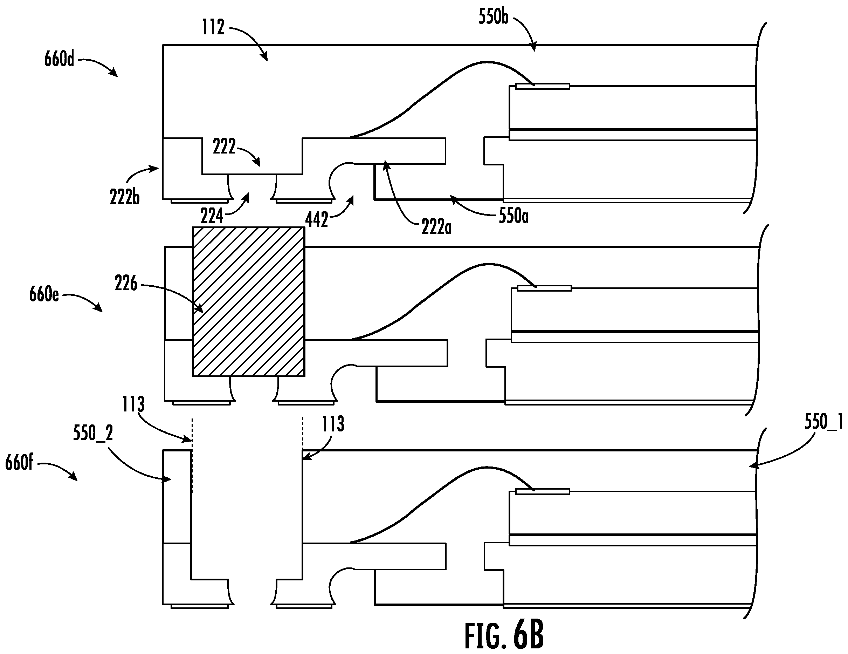

Referring now to FIG. 6B, at step 660d, a connecting portion 224 of the dual conductive lead 222 connecting the first portion 222a and the second portion 222b of the dual conductive lead 222 is etched. The dual conductive lead 222 is etched into two separate portions, the first portion 222a and the second portion 222b. However, the molding material 112 above and around the dual conductive lead 222 remains intact. The molding material 112 provides rigidity to the plurality of lead-frame packages during transfer and a singulation process. The etched connecting portion 224 may be removed using any wet etch, dry etch, or similar process.

As further depicted in step 660d, the conductive lead recess 442 is formed by removing a portion of the conductive lead. In some embodiments, the portion of the conductive lead may be removed during the etching process used to remove the connecting portion 224. Although not depicted in FIG. 6B, the first side recess 444a and the second side recess 444b may be formed during the etching process of step 660d.

At step 660e, a singulation process is performed. The singulation process removes the molding material 112 separating neighboring lead-frame packages. In a strip molding process, rows and columns are separated during the singulation process. The singulation process may include any process for cutting or removing the molding material 112 between lead-frame packages. For example, the singulation process may include a mechanical cutting process in which a rotating blade 226 is used to separate the lead-frame packages. In addition, the singulation process may include a laser cutting process in which a laser is used to cut the molding material 112 to separate the lead-frame packages.

As depicted in step 660f, once the molding material 112 is removed, the lead-frame packages 550_1, 550_2 are completely separated into separate lead-frame packages 550_1, 550_2. The singulation process further defines the boundary of each lead-frame package 550_1, 550_2 and the perimeter 113 of the lead-frame package 550_1, 550_2.

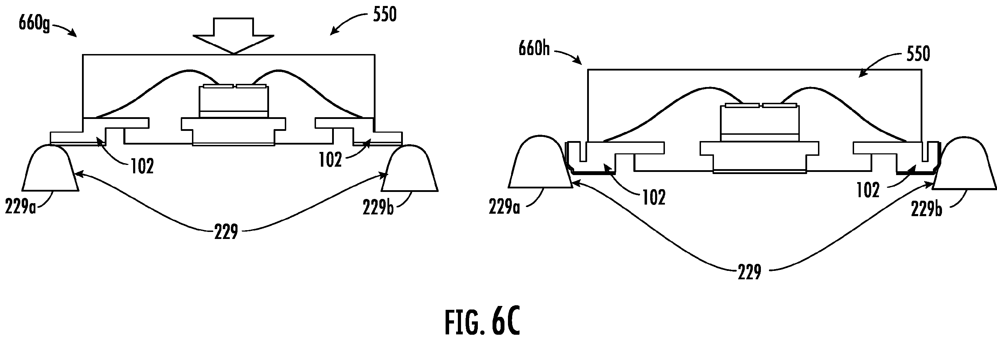

Referring now to FIG. 6C, the conductive leads 102 are bent vertically, exposing a solder wettable surface 118 of the conductive lead 102 in a lateral direction.

As shown in step 660g, the lead-frame package 550 with conductive leads 102 extending past the perimeter defined by the molding material are pushed into a forming pocket 229 having a first protrusion 229a and a second protrusion 229b. The first protrusion 229a and the second protrusion 229b are spaced wider than the perimeter of the lead-frame package 100 but narrower than the full extent of the conductive leads 102, such that the downward force of the lead-frame package 550 into the forming pocket 229 causes the conductive leads 102 to bend vertically. In some embodiments, the first protrusion 229a and the second protrusion 229b may be rounded or otherwise shaped to promote the vertical bend of the conductive leads 102.

As shown in step 660h, in an instance in which the lead-frame package 550 is forced downward into the forming pocket 229, the conductive leads 102 extending outside the perimeter of the lead-frame package 100 are bent vertically. In some embodiments, a plurality of lead-frame packages 100 may be simultaneously forced into a forming pocket 229 such that the conductive leads 102 on a plurality of lead-frame packages are bent simultaneously. For example, in a strip molding process, an entire row or column of lead-frame packages 100 may be forced into a forming pocket 229 before the lead-frame packages of the row or column are separated.

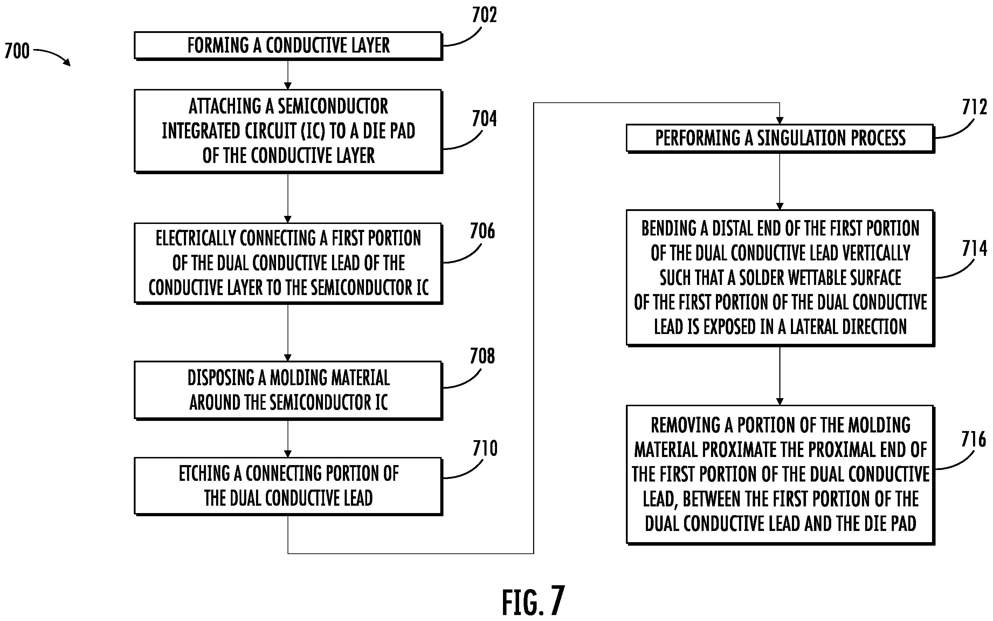

Referring now to FIG. 7, a flow diagram of an example method 700 for manufacturing a lead-frame package (e.g., lead-frame package 100, 440, 550) with improved conductive lead structure is provided. At block 702, a conductive layer is formed, the conductive layer comprising a dual conductive lead (e.g., dual conductive lead 222) having a first portion (e.g., first portion 222a) and a second portion (e.g., second portion 222b), and a die pad (e.g., die pad 108) electrically insulated from the dual conductive lead.

At block 704, a semiconductor IC (e.g., semiconductor IC 104) is attached to the die pad.

At block 706, the first portion of the dual conductive lead is electrically connected to the semiconductor IC. In addition, the second portion of the dual conductive lead may be electrically connected to a neighboring semiconductor IC.

At block 708, a molding material (e.g., molding material 112) is disposed around the semiconductor IC, wherein an exposed surface of the dual conductive lead is uncovered by the molding material. The exposed surface further includes a solder wettable surface configured to promote solder adhesion. Such a surface may be designed to align with a conductive pad on a substrate material, such as a PCB.

At block 710, a connecting portion (e.g., connecting portion 224) of the dual conductive lead is etched, wherein the connecting portion connects the first portion of the dual conductive lead to the second portion of the dual conductive lead. Although the connecting portion of the dual conductive lead is etched, the molding material connecting neighboring lead-frame packages remains intact. As such, the molding material provides stability to the array of lead-frame packages during transition to the singulation process.

At block 712, a singulation process is performed, separating the first portion of the dual conductive lead and the electrically connected semiconductor IC from the second portion of the dual conductive lead. The singulation process further defines a perimeter (e.g., perimeter 113) of the molding material of the lead-frame package comprising the semiconductor IC. As a result of the singulation process, the first portion of the dual conductive lead comprises a proximal end (e.g., proximal end 102b) and a distal end (e.g., distal end 102a), the distal end extending beyond the perimeter of the lead-frame package, while the proximal end remains attached to the molding material within the perimeter of the lead-frame package.

At block 714, the distal end of the first portion of the dual conductive lead is bent vertically such that a solder wettable surface (e.g., solder wettable surface 118) of the first portion of the dual conductive lead is exposed in a lateral direction (e.g., lateral direction 119). Any method may be utilized to bend the conductive leads vertically. For example, one or more lead-frame packages may be forced into a forming pocket (e.g., forming pocket 229) causing the distal end of the conductive leads to be forced vertically. In some embodiments, an interior radius (e.g., inner radius 334) of the vertically bent conductive lead may be equivalent to, or nearly equivalent to a distal end thickness (e.g., distal end thickness 332) of the conductive lead.

At block 716, a portion of the molding material is removed proximate the proximal end of the first portion of the dual conductive lead, between the first portion of the dual conductive lead and the die pad. In some embodiments, a portion of the dual conductive lead may be removed at between the proximal end of the conductive lead and the die pad, opposite the distal end of the conductive lead, forming a conductive lead recess (e.g., conductive lead recess 442). In some embodiments, a portion of the dual conductive lead may be removed on either side of the proximal end of the conductive lead (e.g., first side 102c, second side 102d), forming a side recess (e.g., first side recess 444a, second side recess 444b). In some embodiments, each of the conductive lead recess, first side recess, and second side recess may be formed around one or more conductive leads. The formation of the recesses proximate the conductive lead and the vertically bent conductive leads all provide flexibility to the electrical connection between the lead-frame package and the supporting substrate. The added flexibility may improve the reliability of the electrical system, particularly in harsh environments in which electrical components may expand and contract.

While this detailed description has set forth some embodiments of the present invention, the appended claims cover other embodiments of the present invention which differ from the described embodiments according to various modifications and improvements. For example, one skilled in the art may recognize that such principles may be applied to any electrical component utilizing a lead-frame package to electrically connect to an electrical system.

Within the appended claims, unless the specific term "means for" or "step for" is used within a given claim, it is not intended that the claim be interpreted under 35 U.S.C. 112, paragraph 6.

Use of broader terms such as "comprises," "includes," and "having" should be understood to provide support for narrower terms such as "consisting of," "consisting essentially of," and "comprised substantially of" Use of the terms "optionally," "may," "might," "possibly," and the like with respect to any element of an embodiment means that the element is not required, or alternatively, the element is required, both alternatives being within the scope of the embodiment(s). Also, references to examples are merely provided for illustrative purposes, and are not intended to be exclusive.

## Claims

1. A lead-frame package comprising:
a semiconductor integrated circuit (IC) thermally coupled to a die pad;
a molding material enclosing the semiconductor IC and defining a perimeter of the lead-frame package;
a conductive lead electrically connected to the semiconductor IC and exposed at a surface of the lead-frame package, the conductive lead having a proximal end and a distal end,
wherein the distal end of the conductive lead extends beyond the perimeter of the lead-frame package, the distal end of the conductive lead bent vertically such that a solder wettable surface of the conductive lead is exposed in a lateral direction,
wherein the molding material insulates the conductive lead from the die pad; and
a conductive lead recess defined between the proximal end of the conductive lead and the die pad.

2. The lead-frame package of claim 1, wherein the conductive lead is electrically coupled to the semiconductor IC by a conductive bond wire.

3. The lead-frame package of claim 1, wherein the conductive lead is attached to a conductive pad of a printed circuit board (PCB).

4. The lead-frame package of claim 1, wherein the molding material comprises at least one of a resin and a polymer plastic.

5. The lead-frame package of claim 1, wherein the lead-frame package comprises a quad-flat no-leads (QFN) package.

6. The lead-frame package of claim 1, the conductive lead further comprising a first side and a second side, wherein a first side recess is defined proximate the first side.

7. The lead-frame package of claim 6, wherein a second side recess is defined proximate the second side.

8. The lead-frame package of claim 1, the conductive lead further comprising a distal end thickness, wherein an interior radius of the distal end of the conductive lead is equal to the distal end thickness.

9. The lead-frame package of claim 1, wherein the solder wettable surface comprises a plating material configured to promote solder adhesion.

10. A method of manufacturing a lead-frame package, comprising:
forming a conductive layer comprising:
a dual conductive lead having a first portion and a second portion, and
a die pad electrically insulated from the dual conductive lead;
attaching a semiconductor integrated circuit (IC) to the die pad;
electrically connecting the first portion of the dual conductive lead to the semiconductor IC;
disposing a molding material around the semiconductor IC, wherein an exposed surface of the dual conductive lead is uncovered by the molding material;
etching a connecting portion of the dual conductive lead, wherein the connecting portion connects the first portion of the dual conductive lead to the second portion of the dual conductive lead;
performing a singulation process, separating the first portion of the dual conductive lead and electrically connected semiconductor IC from the second portion of the dual conductive lead,
wherein the singulation process defines a perimeter of the molding material of the lead-frame package comprising the semiconductor IC, and
wherein the first portion of the dual conductive lead comprises a proximal end and a distal end, the distal end extending beyond the perimeter of the lead-frame package;
bending the distal end of the first portion of the dual conductive lead vertically such that a solder wettable surface of the first portion of the dual conductive lead is exposed in a lateral direction; and
removing a portion of the molding material proximate the proximal end of the first portion of the dual conductive lead, between the first portion of the dual conductive lead and the die pad.

11. The method of claim 10, wherein etching the connecting portion of the dual conductive lead, is performed prior to performing the singulation process.

12. The method of claim 10, wherein performing the singulation process utilizes a laser cutting process.

13. The method of claim 10, wherein the second portion of the dual conductive lead comprises a portion of a second lead-frame package.

14. The method of claim 10, wherein bending the distal end of the first portion of the dual conductive lead vertically further comprises driving the lead-frame package into a forming pocket.

15. The method of claim 10, wherein the molding material comprises at least one of a resin and a polymer plastic.

16. The method of claim 10, wherein the lead-frame package comprises a quad-flat no-leads (QFN) package.

17. The method of claim 10, the first portion of the dual conductive lead further comprising a first side and a second side, the method further comprising:
removing a first side portion of molding material proximate the first side of the first portion of the dual conductive lead.

18. The method of claim 17, further comprising removing a second side portion of molding material proximate the second side of the first portion of the dual conductive lead.

19. The method of claim 10, the first portion of the dual conductive lead further comprising a distal end thickness, wherein an interior radius of the distal end of the first portion of the dual conductive lead is equal to the distal end thickness.

20. An electrical system, comprising:
a printed circuit board (PCB) comprising a conductive pad; and
a lead-frame package comprising:
a semiconductor integrated circuit (IC) thermally coupled to a die pad;
a molding material enclosing the semiconductor IC and defining a perimeter of the lead-frame package;
a conductive lead electrically connected to the semiconductor IC and exposed at a surface of the lead-frame package, the conductive lead having a proximal end and a distal end,
wherein the distal end of the conductive lead extends beyond the perimeter of the lead-frame package, the distal end of the conductive lead bent vertically such that a solder wettable surface of the conductive lead is exposed in a lateral direction relative to the surface of the PCB,
wherein the molding material insulates the conductive lead from the die pad; and
a conductive lead recess defined between the proximal end of the conductive lead and the die pad;
wherein the distal end of the conductive lead is electrically connected to the conductive pad of the PCB.
